# FASCICULE DE BREVET EUROPEEN

(11) **EP 4 268 284 B1**
(45) Date de publication et mention de la délivrance du brevet: **25.09.2024**
(21) Numéro de dépôt: 21840923.3
(22) Date de dépôt: 20.12.2021
(51) Int. Cl.: H01L 31/0203, H01L 31/02, H01L 31/0352, H01L 31/0232, H01L 31/18, H01L 27/146, H01L 33/58, H01L 33/62

(54) **PROCÉDÉ DE MISE EN COURBURE COLLECTIVE DE COMPOSANTS MICROELECTRONIQUES COMPORTANT UN REPORT DES COMPOSANTS MICROELECTRONIQUES ALORS ASSEMBLÉS À UNE POIGNÉE TEMPORAIRE**
VERFAHREN ZUM KOLLEKTIVEN BIEGEN MIKROELEKTRONISCHER KOMPONENTEN, EINSCHLIESSLICH DER ÜBERTRAGUNG DER ZUSAMMENGESETZTEN MIKROELEKTRONISCHEN KOMPONENTEN MIT EINEM TEMPORÄREN TRÄGER
METHOD FOR COLLECTIVELY BENDING MICROELECTRONIC COMPONENTS, INCLUDING TRANSFERRING THE ASSEMBLED MICROELECTRONIC COMPONENTS WITH A TEMPORARY HANDLE

(30) Priorité: 22.12.2020 FR 2013969
(43) Date de publication de la demande: 01.11.2023
(73) Titulaire: Commissariat à l'Energie Atomique et aux Energies Alternatives, 75015 Paris (FR)
(72) Inventeur: HENRY, David, 38054 GRENOBLE Cedex 09 (FR); ROCHAS, Alexis, 38054 GRENOBLE Cedex 09 (FR)
(74) Mandataire: Brevalex
(86) Numéro de dépôt international: PCT/EP2021/086756
(87) Numéro de publication internationale: WO 2022/136253

(56) Documents cités:
- JP-A- 2020 109 821
- US-A1- 2009 115 875
- US-A1- 2018 145 107
- US-A1- 2019 140 008
- US-A1- 2020 185 444
- CHAMBION BERTRAND ET AL: "Collective Curved CMOS Sensor Process: Application for High-Resolution Optical Design and Assembly Challenges", 2019 IEEE 69TH ELECTRONIC COMPONENTS AND TECHNOLOGY CONFERENCE (ECTC), IEEE, 28 May 2019 (2019-05-28), pages 535 - 542, XP033603657, DOI: 10.1109/ECTC.2019.00087
- WU HAO ET AL: "Fabrication Techniques for Curved Electronics on Arbitrary Surfaces", ADVANCED MATERIALS TECHNOLOGIES, vol. 5, no. 8, 20 May 2020 (2020-05-20), DE, pages 2000093, XP055833808, ISSN: 2365-709X, DOI: 10.1002/admt.202000093

## Description

### DOMAINE TECHNIQUE

Le domaine de l'invention est celui des procédés de mise en courbure collective et de packaging de composants microélectroniques, et en particulier celui des procédés mis en oeuvre « au niveau de la plaque semiconductrice » (WLP pour *Wafer-Level Packaging,* en anglais), voire même celui des procédés de type WLCSP (pour *Wafer-level Chip-Scale Packaging,* en anglais), c'est-à-dire que la structure finale formée du composant microélectronique et de son support d'interconnexion électrique peut présenter des dimensions latérales du même ordre que celles du composant microélectronique.

### ÉTAT DE LA TECHNIQUE ANTÉRIEURE

Il peut être souhaitable de disposer de composants microélectroniques, et en particulier de composants optoélectroniques, présentant une courbure prédéfinie vis-à-vis d'un plan de référence. C'est le cas notamment lorsqu'il s'agit de composants optiques de détection ou d'émission d'un rayonnement lumineux, dont la courbure permet d'améliorer leurs performances optiques, par exemple en compensant la courbure de champ ou en corrigeant au moins partiellement l'astigmatisme. Dans le cas de composants optiques en émission, la courbure peut permettre de faciliter la mise en forme du rayonnement lumineux émis.

La réalisation et le packaging de tels composants microélectroniques peuvent être effectués à l'échelle du wafer, c'est-à-dire à partir d'une même plaque semiconductrice comportant une pluralité de circuits intégrés identiques destinés à former chacun l'un des composants microélectroniques. Le packaging consiste en l'ensemble des étapes d'assemblage de chaque composant microélectronique dans un boîtier ou un support permettant d'établir sa connexion électrique à un circuit électrique externe, et éventuellement d'en améliorer les performances (gestion thermique, protection mécanique, fiabilité...).

Le document US2009/0115875A1 décrit un exemple de procédé de mise en courbure collective de composants microélectroniques, ici des composants optiques, sur un support de mise en forme et d'interconnexion électrique. Les composants microélectroniques sont tout d'abord réalisés à partir d'un même substrat fonctionnalisé. Ils sont revêtus d'une couche de support supérieure en un matériau polymère flexible et transparent, et par une couche de support inférieure en un autre matériau polymère. Ils sont ensuite individualisés par découpe (*dicing,* en anglais), puis sont reportés sur le même support de mise en forme. Ce support de mise en forme présente une pluralité de surfaces courbées (ici concaves). Il comporte également des interconnexions électriques permettant d'établir la connexion électrique entre les composants microélectroniques et un circuit électrique externe (non représenté).

Cependant, il apparaît qu'un tel procédé de mise en courbure peut induire une courbure des composants microélectroniques qui n'est pas celle effectivement désirée.

Par ailleurs, on connaît également les documents US2019/ 140008A1, US2020/185444A1, US2018/145107A1, JP2020109821A, et la publication de Chambion et al. intitulée Collective Curved CMOS Sensor Process: Application for High-Resolution Optical Design and Assembly Challenges, 69th Electronic Components and Technology Conférence, p.535-542, 2019.

### EXPOSÉ DE L'INVENTION

L'invention a pour objectif de remédier au moins en partie aux inconvénients de l'art antérieur, et plus particulièrement de proposer un procédé de mise en courbure collective de composants microélectroniques qui permet d'obtenir une courbure effective des composants microélectroniques aussi proche que possible de la courbure souhaitée.

Pour cela, l'objet de l'invention est un procédé de mise en courbure collective de composants microélectroniques comportant les étapes suivantes :
∘ réalisation d'une structure initiale, comportant : une pluralité de composants microélectroniques, présentant une face supérieure et une face inférieure opposées, espacés latéralement les uns des autres d'une distance lt non nulle ; et un même substrat poignée temporaire, réalisé en un matériau rigide, qui s'étend continûment en regard des composants microélectroniques, et auquel les composants microélectroniques sont tous assemblés par leur face supérieure ;
∘ fourniture d'un support de mise en forme, présentant une face supérieure et une face inférieure opposée, la face supérieure comportant une pluralité de surfaces courbées entourées par des parois latérales ;
∘ dépôt d'une couche adhésive intercalaire recouvrant la face inférieure des composants microélectroniques ou la face supérieure du support de mise en forme ;
∘ report de la structure initiale sur le support de mise en forme, de sorte que les composants microélectroniques reposent et adhérent au niveau d'une zone d'appui de leur face inférieure sur une surface supérieure des parois latérales ;
∘ retrait du substrat poignée temporaire ;
∘ mise en courbure des composants microélectroniques, de sorte qu'ils soient incurvés, et adhérent sur les surfaces courbées par la couche adhésive intercalaire, celle-ci étant alors au contact de la face inférieure de chaque composant microélectronique et de la surface courbée correspondante ;
∘ découpe de l'ensemble ainsi obtenu, de manière à individualiser les composants microélectroniques, chacun étant alors assemblée à une partie du support de mise en forme.

Certains aspects préférés mais non limitatifs de ce procédé sont les suivants.

L'étape de réalisation de la structure initiale peut comporter les étapes suivantes : réalisation d'un substrat microélectronique, présentant une face supérieure et une face inférieure opposée, comportant la pluralité de composants microélectroniques ; réalisation de tranchées dans le substrat microélectronique, à partir de sa face supérieure, entourant les composants microélectroniques, et présentant une largeur égale à la distance lt ; assemblage du substrat microélectronique par sa face supérieure au substrat poignée temporaire ; amincissement du substrat microélectronique à partir de sa face inférieure, jusqu'à rendre traversantes les tranchées.

Le procédé peut comporter, avant l'étape de retrait, une montée en température à une première température comprise dans une gamme de température de réticulation de la couche adhésive intercalaire, puis, pendant ou après l'étape de mise en courbure, une montée en température à une deuxième température comprise dans la gamme de température de réticulation et supérieure à la première température.

Le procédé peut comporter une étape préalable de détermination d'une largeur lₐ de la zone d'appui, comprise entre une valeur minimale prédéfinie l_{a,min} et une valeur maximale l_{a,max} prédéterminée, celle-ci dépendant d'un rayon de courbure R_{c} et de dimensions latérales l_{sc} des surfaces courbées, et de dimensions latérales l_{co} des composants microélectroniques avant mise en courbure.

La face inférieure des composants microélectroniques peut être, avant le dépôt de la couche adhésive intercalaire, une face libre, la couche adhésive intercalaire étant déposée de manière à présenter une épaisseur constante sur la face inférieure des composants microélectroniques ou sur la face supérieure du support de mise en forme.

Avant l'étape de retrait du substrat poignée temporaire, le procédé peut comporter une étape de réalisation de plots conducteurs inférieurs sur la face inférieure des composants microélectroniques, adaptés à assurer la connexion électrique des composants microélectroniques, et disposés sur une ligne de niveau d'une face inférieure du composant microélectronique correspondant, la ligne de niveau étant prédéterminée comme étant une ligne d'égale distance à la face inférieure du support de mise en forme, lorsque le composant microélectronique est assemblé au support de mise en forme et est incurvé selon la courbure de la surface courbée.

Avant l'étape de retrait du substrat poignée temporaire, le procédé peut comporter une étape de réalisation de plots conducteurs supérieurs sur la face supérieure des composants microélectroniques, et des vias conducteurs s'étendant à partir de la face inférieure des composants microélectroniques et débouchant sur les plots conducteurs supérieurs, les plots conducteurs inférieurs étant connectés aux vias conducteurs des composants microélectroniques.

Après l'étape de mise en courbure, un deuxième substrat poignée peut être assemblé aux parois latérales du support de mise en forme, de manière à permettre la manipulation de l'empilement ainsi obtenu lors d'une étape de réalisation des vias conducteurs dans le support de mise en forme.

Après l'étape de mise en courbure, le procédé peut comporter une étape de réalisation des vias conducteurs s'étendant au travers du support de mise en forme et de la couche adhésive intercalaire, à partir de la face inférieure du support de mise en forme pour déboucher sur les plots conducteurs inférieurs, les vias conducteurs présentant une dimension verticale uniforme.

Les plots conducteurs inférieurs peuvent être disposés au contact des vias conducteurs des composants microélectronique, ou peuvent être décalés vis-à-vis de ces vias conducteurs et en être reliés par des lignes conductrices.

La couche adhésive intercalaire peut recouvrir entièrement la face inférieure des composants microélectroniques ainsi que les plots conducteurs inférieurs, et présente une face inférieure libre, plane et continue.

Le substrat de mise en forme peut être réalisé en un seul bloc et en un même matériau.

Le substrat de mise en forme peut être réalisé en un matériau thermiquement conducteur.

Les composants microélectroniques peuvent être des composants optiques d'émission ou de détection d'un rayonnement lumineux.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1M illustrent différentes étapes d'un mode de réalisation d'un procédé de mise en forme collective de composants microélectroniques, dans le cas où une couche adhésive intercalaire est déposée sur la face supérieure du support de mise en forme ;
les figures 2A à 2C illustrent différentes étapes d'une variante de réalisation d'un procédé de mise en forme collective de composants microélectroniques, dans le cas où la couche adhésive intercalaire est déposée sur la face inférieure des composants microélectroniques ;
les figures 3A à 3I illustrent différentes étapes d'une autre variante de réalisation d'un procédé de mise en forme collective de composants microélectroniques, dans le cas où le support de mise en forme assure l'interconnexion électrique des composants microélectroniques à partir de sa face inférieure.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de mise en courbure collective de composants microélectroniques. Ces derniers sont issus d'un même substrat fonctionnalisé, c'est-à-dire qu'ils sont réalisés selon une approche WLP. Par ailleurs, selon une variante de réalisation, au terme du procédé de mise en courbure, chaque ensemble formé d'un composant microélectronique assemblé à son support de mise en forme peut présenter des dimensions latérales du même ordre que celle du composant microélectronique lui-même. Aussi, le procédé de mise en courbure collective peut appartenir à la famille des procédés de type WLCSP.

Dans le cas de l'invention, un composant microélectronique comporte un circuit intégré qui peut comporter des éléments microélectroniques actifs tels que des transistors ou des diodes, et/ou des éléments optoélectroniques actifs tels que des diodes électroluminescentes ou des photodétecteurs. Les composants microélectroniques sont réalisés à partir d'un même substrat semiconducteur (ou plaque semiconductrice, *wafer* en anglais).

Dans la suite de la description, les composants microélectroniques sont des composants optiques (mais ils peuvent évidemment être des composants de type hyperfréquence, voire des composants MEMS, entre autres). D'une manière générale, ces derniers peuvent être à transmission optique en face avant (FSI, pour *Front Side Illumination,* en anglais) ou à transmission optique en face arrière (BSI, pour *Back Side Illumination*), selon que le rayonnement lumineux d'intérêt traverse ou non une couche d'interconnexion de type BEOL (pour *Back End of Line*) du composant optique. Cependant, les termes « FSI » et « BSI » sont ici à prendre au sens large : le composant optique peut ainsi être adapté à émettre ou à détecter un rayonnement lumineux d'intérêt. Dans les exemples illustrés par la suite, les composants optiques sont matriciels (mais peuvent ne pas l'être), et comportent chacun une matrice de photodiodes associée à une matrice de microlentilles.

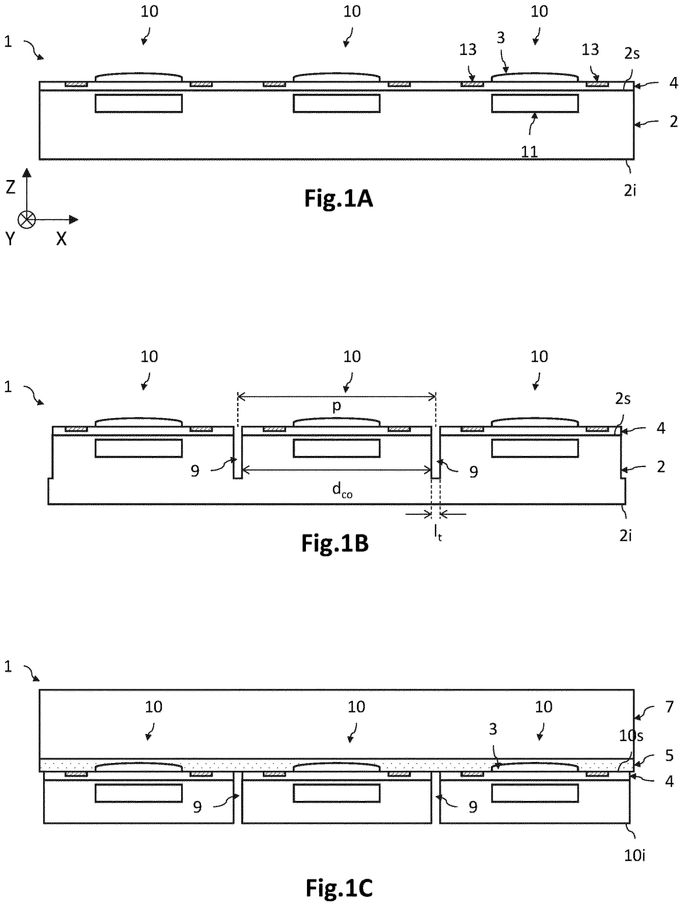

Les figures 1A à 1M illustrent différentes étapes du procédé de mise en courbure collective de composants microélectroniques 10, ici des composants optiques, sur un support de mise en forme. Les matrices de photodiodes 11 et de microlentilles 3 sont représentées de manière simplifiée, ceci pour privilégier la clarté des figures. Dans cet exemple, les composants optiques 10 sont donc de type FSI, mais une configuration BSI est également possible.

On définit ici et pour la suite de la description un repère direct tridimensionnel orthogonal XYZ, où les axes X et Y forment un plan parallèle à la face supérieure d'un substrat optique 2, et où l'axe Z est orienté de la face inférieure 2i à la face supérieure 2s de ce dernier. Dans la suite de la description, les termes « inférieur » et « supérieur » sont relatifs à un positionnement croissant suivant la direction +Z.

En référence à la fig. 1A, on réalise une structure dite initiale 1 comportant un substrat semiconducteur fonctionnalisé 2, dit ici substrat optique. Dans cet exemple, la structure initiale 1 comporte également une matrice de microlentilles 3, assemblée au substrat optique 2 par une couche supérieure isolante 4. La structure initiale 1 comporte une pluralité de composants optiques 10, destinés à être individualisés.

Le substrat optique 2 présente une face supérieure 2s destinée ici à recevoir un rayonnement lumineux d'intérêt, et une face inférieure 2i opposée. Il peut présenter une épaisseur initiale de l'ordre de plusieurs centaines de microns. Son épaisseur est destinée à être réduite à une valeur par exemple comprise entre 20µm et 150µm. Dans cet exemple, les composants optiques 10 sont des imageurs CMOS, le substrat optique 2 étant alors un substrat épais réalisé par exemple à base de silicium. En variante, les composants optiques 10 peuvent être des capteurs CCD.

Chaque composant optique 10 comporte ici une matrice de photodiodes 11 réalisées par exemple par implantation ionique localisée de dopants dans le silicium du substrat optique 2. Dans cette configuration FSI, une couche d'interconnexion (BEOL) affleure la face supérieure 2s. Elle assure la commande ou la lecture (alimentation) des photodiodes 11. Elle est donc destinée à être connectée électriquement à un circuit électrique externe (non représenté). La couche d'interconnexion comporte des portions de lignes conductrices, par exemple métalliques, séparées les unes des autres par un matériau diélectrique (par exemple un oxyde et/ou nitrure de silicium, selon la longueur d'onde du rayonnement lumineux d'intérêt).

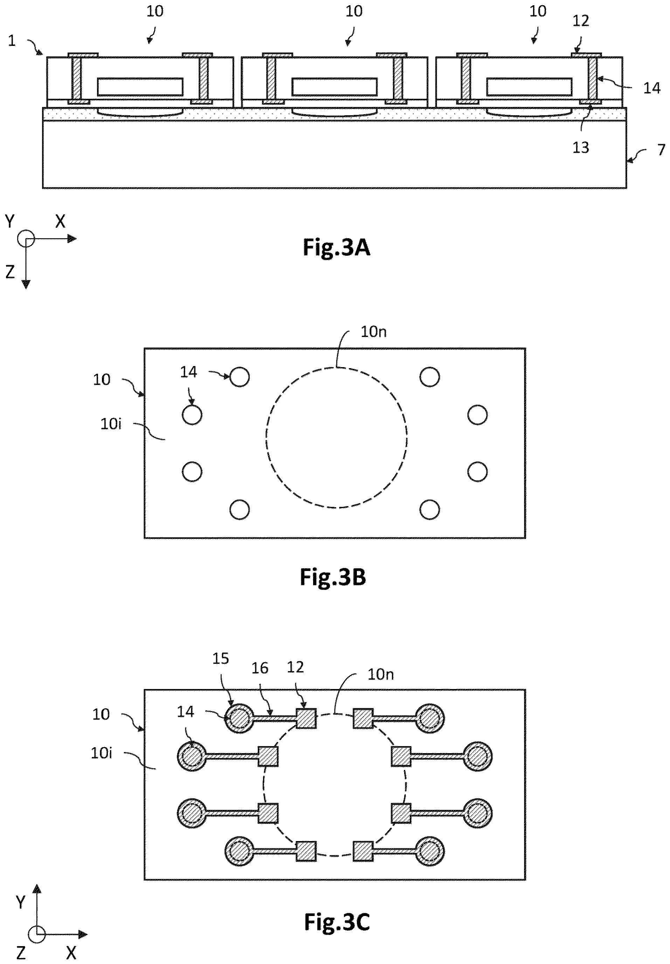

Chaque composant optique 10 comporte ici des plots conducteurs supérieurs 13 reposant sur la face supérieure 2s du substrat optique 2, connectés à la couche d'interconnexion. Aussi, la connexion électrique des plots conducteurs supérieurs 13 permet d'assurer les différentes fonctions nécessaires (polarisation, alimentation, traitement des entrées/sorties, mise à la masse, etc.). En variante, comme illustré sur les fig.3A à 3I, la connexion électrique des photodiodes 11 peut être effectuée à partir de la face inférieure.

Une couche supérieure isolante 4, réalisée en un matériau diélectrique et transparent au rayonnement lumineux d'intérêt, recouvre la face supérieure 2s et contient des lignes conductrices qui débouchent sur les plots 13. Il s'agit d'une couche diélectrique inter-couche (ILD, pour *Inter-Layer Dielectric*). Les plots 13 peuvent être des portions d'une ligne conductrice (ici la dernière ligne conductrice). D'autres agencements de cette dernière sont bien entendu possibles. Par ailleurs, la structure initiale 1 peut également comporter une matrice de filtres colorés, des couches antireflets, ou tout autre élément optique passif.

En référence à la fig. 1B, on réalise des tranchées 9 dans la structure initiale 1, de manière à pré-individualiser les composants optiques 10, à partir de leur face supérieure. Cette étape peut être effectuée par sciage mécanique ou par gravure laser, de manière à traverser la couche supérieure isolante 4 et à s'étendre suivant une partie de l'épaisseur du substrat optique 2. Les tranchées 9 sont des échancrures non traversantes qui ne débouchent pas sur la face inférieure 2i. Les tranchées 9 entourent les composants optiques 10 et s'étendent sur une profondeur qui définit l'épaisseur finale du substrat optique 2, par exemple ici sur une profondeur de l'ordre de 20µm à 150µm. Elles présentent une largeur lₜ dans le plan XY et s'étendent de manière longitudinale de manière à définir la forme des composants optiques 10 dans le plan XY. Cette forme peut être polygonale, par exemple carrée ou rectangulaire, voire circulaire ou ovale. Dans cet exemple, les composants optiques 10 présentent une forme carrée dans le plan XY de côté d_{co}. Les tranchées 9 sont espacées les unes des autres de manière régulière au pas p.

En référence à la fig. 1C, on assemble le substrat optique 2 à un substrat poignée 7 temporaire, du côté de la face supérieure 2s. Le substrat poignée 7 est réalisé dans un matériau rigide, réalisé par exemple en verre ou en silicium. Par matériau rigide, on entend un matériau présentant des propriétés mécaniques, et notamment une raideur, telles que le substrat poignée 7 ne se déforme sensiblement pas (de manière élastique) vis-à-vis du plan suivant lequel il s'étend lorsqu'il est manipulé. Autrement dit, lorsque le substrat poignée 7 est manipulé, il ne présente sensiblement pas de déflexion. A titre d'exemple, le substrat poignée 7 est réalisé en un matériau présentant un module d'Young compris entre 1 et 400GPa, et peut être du verre, un polymère durci comme de l'époxy, un matériau cristallin tel que du silicium, un matériau métallique, entre autres.

Pour cela, on peut déposer une couche adhésive supérieure 5, de manière à recouvrir le substrat optique 2. Dans cet exemple, cette couche adhésive 5 s'étend sur et au contact de la couche supérieure isolante 4 et des microlentilles 3. Elle présente une face supérieure plane. Cette couche adhésive 5 est de préférence temporaire. Elle peut être réalisée en un matériau thermoplastique, tel que le matériau HT1010 commercialisé par la société Brewer Science. Ensuite, on assemble le substrat poignée 7 à la face libre de la couche adhésive supérieure 5.

On réalise ensuite un amincissement du substrat optique 2, à partir de sa face inférieure 2i, par exemple par polissage mécanique en présence ou non d'une solution contenant des particules abrasives, puis avec une finition par polissage mécano-chimique, attaque chimique, gravure plasma fluorée, ou autre. Le substrat optique 2 présente alors une épaisseur finale de l'ordre de 20µm à 150µm, ce qui autorise une mise en courbure des composants optiques 10 tout en préservant leurs propriétés mécaniques. L'amincissement est effectué jusqu'à rendre traversantes les tranchées 9. On obtient ainsi une même structure dans laquelle les composants optiques 10 sont séparés et distants les uns des autres de la distance lt, tout en étant tous assemblés au substrat poignée 7.

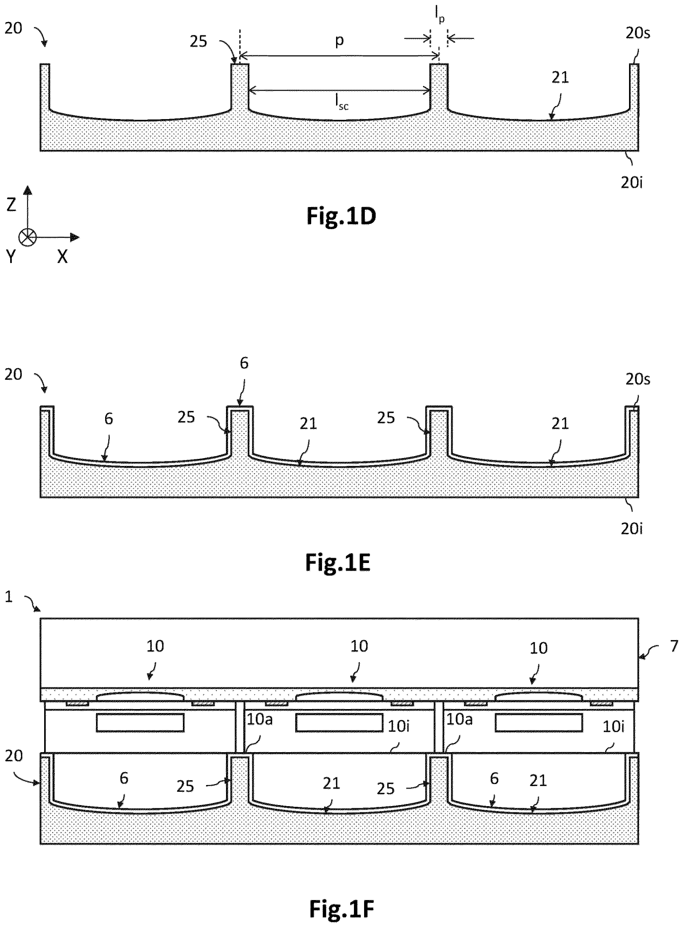

En référence à la fig. 1D, on réalise un support de mise en forme 20. Il présente une face inférieure plane 20i et une face supérieure 20s structurée. Celle-ci est formée de surfaces courbées 21 séparées les unes des autres par des parois latérales 25. Les surfaces courbées 21 présentent, dans le plan XY, une dimension latérale l_{sc} inférieure à la dimension d_{co}, et les parois latérales 25 présentent une largeur lₚ. Les surfaces courbées 21 sont ici concaves mais elles peuvent être convexes ou présenter une courbure plus complexe. Elles présentent un rayon de courbure R_{c} uniforme d'une surface courbée 21 à l'autre. Elles peuvent présenter des lignes de niveau circulaire ou ovale, ou de toute autre forme. Une ligne de niveau d'une surface courbée 21 est une ligne d'égale distance à la face inférieure 20i du support de mise en forme 20. Les parois latérales 25 sont en saillie vis-à-vis des surfaces courbées 21, et s'étendent longitudinalement autour des surfaces courbées 21.

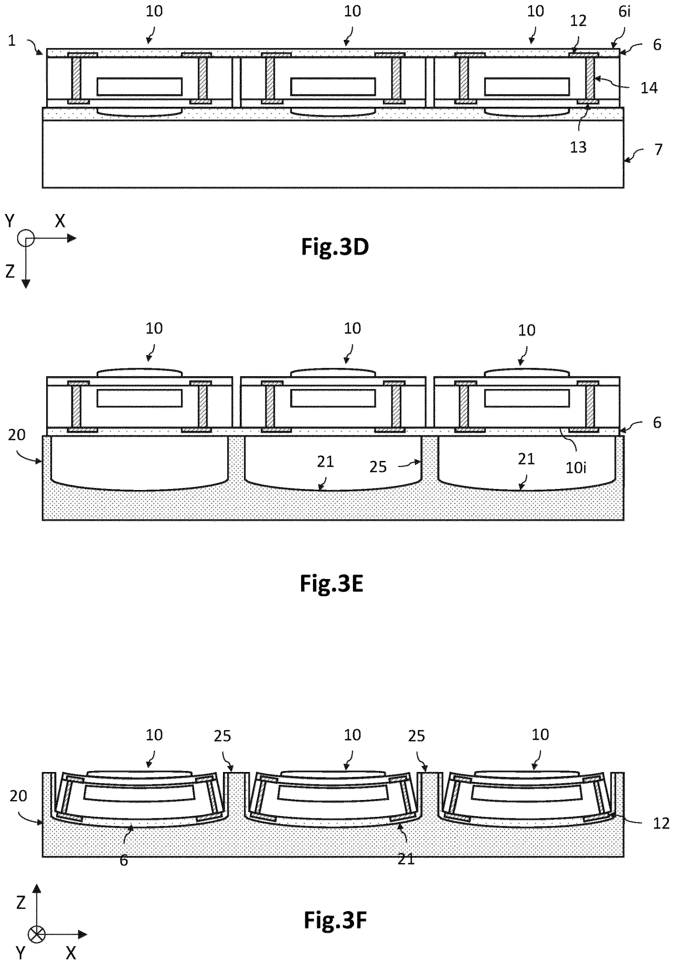

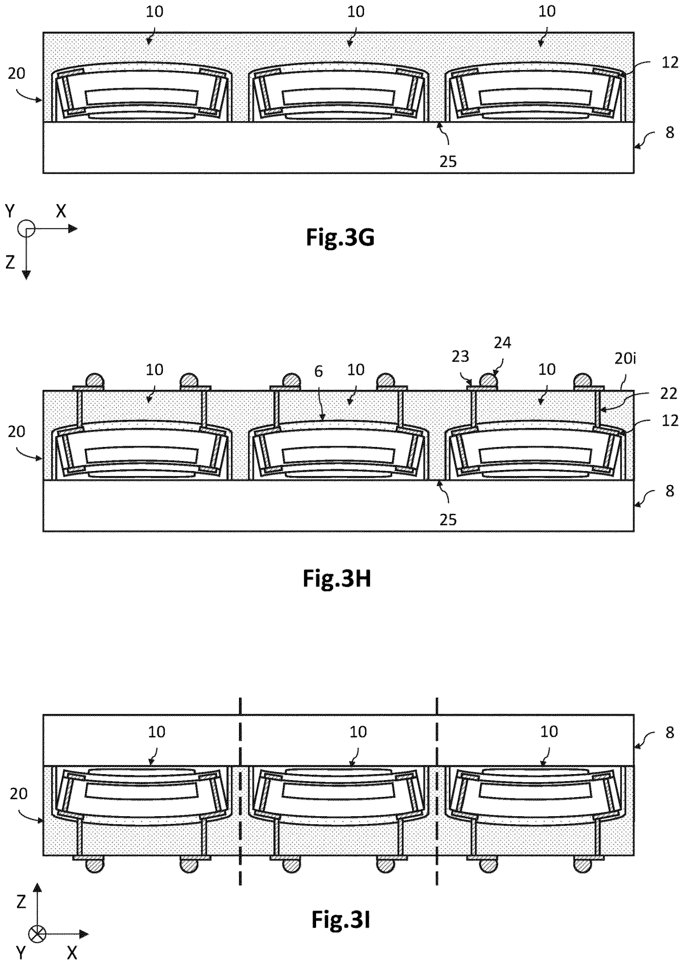

Le support de mise en forme 20 peut être réalisé en un même matériau, ou être formé de plusieurs matériaux différents. Le ou les matériaux peuvent être électriquement isolants ou conducteurs (dans le cas des figures 3, avec une couche isolante entourant les vias conducteurs 22). Le support 20 peut être monobloc, ou être formé de plusieurs blocs ou couches épaisses rapportées et assemblées les unes aux autres, par exemple une couche épaisse plane surmontée d'une couche structurée. Dans cet exemple, le support de mise en forme 20 est réalisé en un même matériau, par exemple du silicium, du métal, un polymère ou autre. Il peut être réalisé en un matériau thermiquement conducteur pour autoriser une meilleure évacuation de la chaleur produite par les composants optiques 10 en fonctionnement.

En référence à la fig. 1E, on dépose une couche adhésive intercalaire 6 sur la face supérieure 20s du support de mise en forme 20. Elle présente une épaisseur uniforme sur la face supérieure 20s, en particulier au moins sur les surfaces courbées 21 et sur la surface supérieure des parois latérales 25. A titre illustratif, l'épaisseur peut être comprise entre 5µm et 100µm, et être par exemple égale à 60µm environ. Comme décrit plus loin, cette couche adhésive 6 peut alternativement être déposée de manière à recouvrir la face inférieure 10i des composants optiques 10 (correspondant à la face inférieure 2i du substrat optique 2). La couche adhésive intercalaire 6 peut être déposée par centrifugation (*spin coating* en anglais), par spray, sérigraphie, laminage d'un film sec, entre autres.

La couche adhésive intercalaire 6 peut s'agir d'une colle polymère dont la réticulation présente une plage de température importante, par exemple comprise entre 80°C et 200°C. Il est donc possible de procéder à sa réticulation en deux temps, c'est-à-dire d'obtenir une première réticulation, partielle, permettant d'assurer le maintien des composants optiques 10 sur les parois latérales 25 lors de l'étape de retrait du substrat poignée 7 tout en autorisant ensuite la mise en courbure collective de ces derniers, puis d'effectuer une deuxième réticulation, totale ou quasi-totale, permettant alors d'assurer le maintien des composants optiques 10 alors situés au niveau des surfaces courbées 21. Une telle colle peut être, à titre d'exemple, la colle Furukawa AFN-601-60M.

En référence à la fig. 1F, on reporte de la structure obtenue lors de l'étape 1C sur le support de mise en forme 20, de sorte que les composants optiques 10 reposent sur les parois latérales 25, la couche adhésive intercalaire 6 étant située entre et au contact de la surface inférieure des composants optiques 10 et de la surface supérieure des parois latérales 25. Plus précisément, les composants optiques 10 reposent sur les parois latérales 25 au niveau d'une zone périphérique de leur face inférieure 10i, définissant une zone d'appui 10a. La largeur de cette zone d'appui 10a, pour chaque composant optique 10, est égale à la moitié de la différence entre la largeur lₚ des parois latérales 25 et la largeur lₜ des tranchées 9 : c'est-à-dire à (lₚ-lₜ)/2.

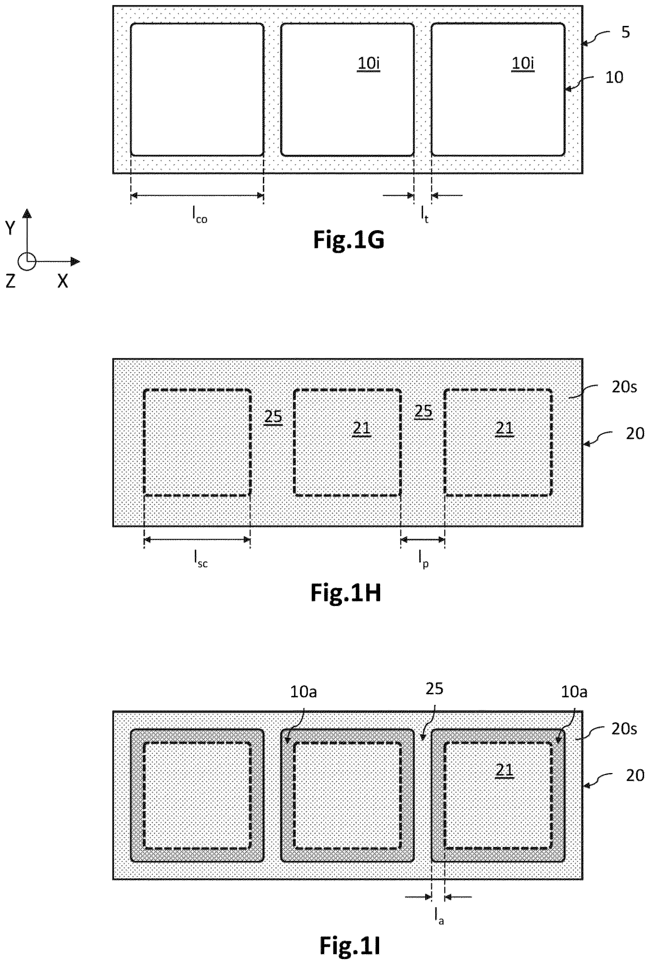

La fig. 1G illustre la face inférieure 10i des composants optiques 10, séparés les uns des autres de la distance lt, et de la couche adhésive supérieure 5. Dans cet exemple, les composants optiques 10 présentent une forme carrée dans le plan XY, de côté l_{co}.

La fig. 1H illustre la face supérieure 20s du support de mise en forme 20. Dans cet exemple, les surfaces courbées 21 présentent une forme carrée dans le plan XY de côté l_{sc}, et un rayon de courbure R_{c} mesuré ici suivant les axes X et Y. Le côté l_{sc} est inférieur au côté l_{co}. De plus, les parois latérales 25 présentent une largeur lₚ supérieure à la largeur lt des tranchées 9.

La fig. 1I illustre la face supérieure 20s du support de mise en forme 20 sur lequel les composants optiques 10 ont été reportés, mettant en évidence la zone d'appui 10a de ces derniers sur les parois latérales 25. La zone d'appui présente une largeur d'appui lₐ non nulle égale à (lₚ-lₜ)/ 2.

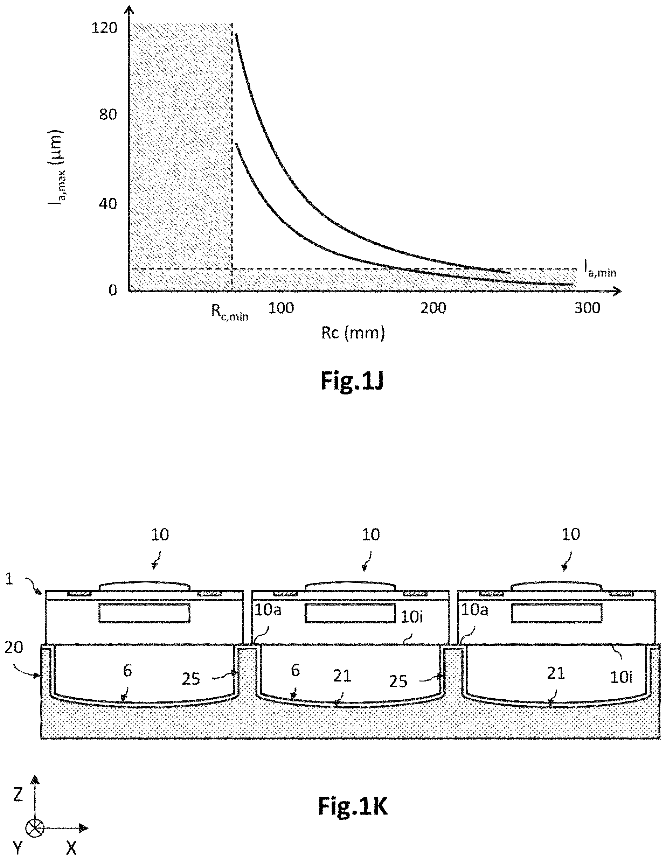

La fig. 1J illustre un exemple d'évolution de la largeur d'appui maximale l_{a,max} de chaque composant optique 10 sur une paroi latérale 25 en fonction du rayon de courbure R_{c} de la surface courbée 21, pour deux exemples de composant optique 10. Le procédé peut en effet comporter une étape préalable de dimensionnement des composants optiques 10 et du support de mise en forme 20, de sorte que les composants optiques 10 présentent une largeur d'appui lₐ suffisante lors de l'étape de retrait du substrat poignée 7, tout en étant en mesure d'être incurvés pour venir contre les surfaces courbées 21.

Ces deux exemples correspondent à des composants optiques 10 de forme carrée dans le plan XY et de côté l_{co} de 25mm et 30mm. Les surfaces courbées 21 sont concaves et de forme carrée. Le rayon de courbure R_{c} est constant, et prend une même valeur suivant l'axe X comme suivant l'axe Y. Ce modèle géométrique permet de déduire, à partir de la largeur l_{co} des composants optiques 10 et du rayon de courbure R_{c}, la largeur d'appui maximale l_{a,max} des composants optiques 10 pour qu'ils puissent être incurvés selon le rayon de courbure R_{c} et venir contre les surfaces courbées 21.

Par ailleurs, on considère que la largeur d'appui lₐ sera de préférence supérieure ou égale à une valeur limite l_{a,min}, ici égale à 10µm, en deçà de laquelle la largeur d'appui lₐ ne sera pas suffisante pour assurer le maintien des composants optiques 10. De plus, on considère que le rayon de courbure R_{c} sera supérieur ou égal à une valeur limite R_{c,min}, par exemple ici égale à 70mm, de manière à éviter toute dégradation des propriétés mécaniques des composants optiques 10 alors incurvés et présentant le rayon de courbure R_{c}.

Aussi, connaissant le rayon de courbure R_{c} voulu et la dimension transversale lₐ des composants optiques 10, il est possible de déterminer une largeur d'appui lₐ comprise entre une valeur minimale l_{a,min} prédéfinie et une valeur maximale l_{a,max} déterminée à partir du modèle géométrique, de sorte que les composants optiques 10 reposent suffisamment sur les parois latérales 25, tout en pouvant ensuite être incurvés suivant le rayon de courbure voulu R_{c} sans être dégradés structurellement.

En référence à la fig. 1K, on retire le substrat poignée 7. Pour cela, avant de procéder au retrait, il est avantageux de procéder à une première réticulation de la couche adhésive intercalaire 6. Celle-ci est effectuée en portant la structure à une première température T₁ de réticulation dite partielle comprise dans la gamme de température de réticulation, ici comprise entre 80°C et 200°C. Cette première température T₁ est inférieure à une deuxième température T₂ de réticulation dite totale appliquée lorsque les composants optiques 10 seront incurvés contre les surfaces courbées 21. Ainsi, la réticulation ici partielle de la couche adhésive intercalaire 6 permet d'améliorer l'assemblage des composants optiques 10 tout en autorisant ensuite leur mise en courbure.

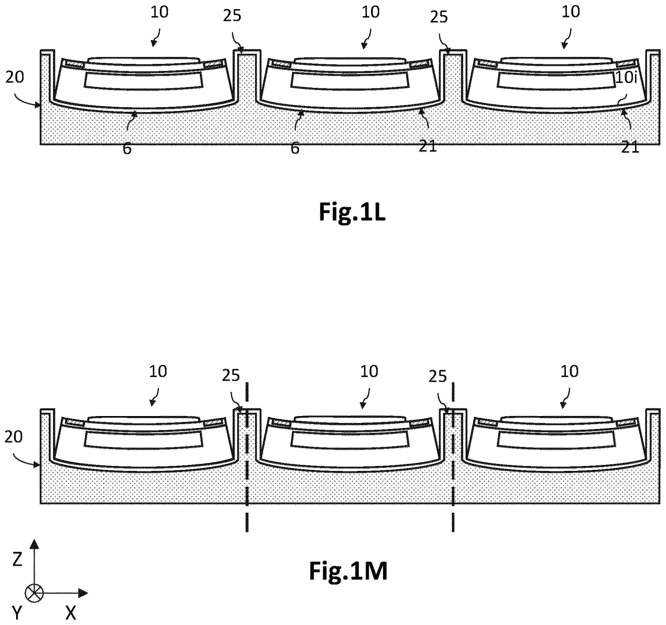

En référence à la fig.1L, on effectue la mise en courbure collective des composants optiques 10. Auparavant, il est avantageux de fragiliser localement la couche adhésive intercalaire 6 au niveau des zones d'appui 10a, de manière à réduire les contraintes mécaniques, notamment de cisaillement, subies par la couche adhésive intercalaire 6 lors de la mise en courbure des composants optiques 10. Pour cela, un tir laser peut être effectué au niveau de la zone d'appui 10a, par exemple au travers du support de mise en forme 20 ou des tranchées 9.

Ensuite, les composants optiques 10 sont incurvés de manière simultanée, jusqu'à ce que leur face inférieure 10i vienne contre la surface courbée 21 correspondante, la couche adhésive intercalaire 6 étant alors située entre et au contact de la face inférieure 10i et de la surface courbée 21. Pour cela, on applique une pression à chacun des composants optiques 10, par exemple par un outil de presse (non représenté), de manière simultanée. Chaque composant optique 10 se déforme et prend la courbure imposée par la surface courbée 21 correspondante. Les composants optiques 10 'glissent' alors le long de la face supérieure du support de mise en forme 20 jusqu'à venir contre les surfaces courbées 21. Ceci est possible dans la mesure où les matériaux des couches adhésives qui réticulent lors d'une montée en température présentent généralement une bonne tenue mécanique à « l'arrachage » (ce qui permet de maintenir les composants optiques 10 lors du retrait du substrat poignée 7) et autorisent toutefois de subir un cisaillement (ce qui permet le glissement des composants optiques 10 lors de leur mise en forme). On obtient ainsi une pluralité de composants optiques 10, tous incurvés suivant la courbure voulue, assemblés au même support de mise en forme 20.

Une montée en température peut également être effectuée pendant ou après la mise en courbure, à une deuxième température T₂ de réticulation de la couche adhésive intercalaire 6, cette température T₂ étant supérieure à la température T₁ précédente, permettant d'obtenir une réticulation plus complète. On améliore ainsi l'assemblage des composants optiques 10 aux surfaces courbées 21.

En référence à la fig. 1M, on effectue la découpe de la structure obtenue, de manière à individualiser les composants optiques 10, suivant les lignes de découpe prédéfinies passant par les parois latérales 25. On obtient ainsi une pluralité de composants optiques 10, distincts les uns des autres, assemblés chacun à une partie du support de mise en forme 20. Une connexion électrique à un circuit électrique externe (non représenté) peut être effectuée par voie filaire (*wire bonding,* en anglais).

Ainsi, le procédé de mise en courbure collective permet d'obtenir une pluralité de composants optiques 10 incurvés et assemblés à une partie d'un même support 20 de mise en forme. Dans la mesure où le report des composants optiques 10 sur le support de mise en forme 20 est effectué au moyen d'un substrat poignée 7, et non pas au moyen de couches de support inférieure et supérieure comme dans l'exemple de l'art antérieur cité précédemment, les composants optiques 10 peuvent effectivement présenter la courbure voulue, définie par celle des surfaces courbées 21. De plus, le fait de réticuler la couche adhésive intercalaire 6 en deux temps permet avantageusement de retirer le substrat poignée 7 avec une meilleure adhérence des composants optiques 10 sur le support de mise en forme 20, puis d'autoriser la mise en forme des composants optiques 10.

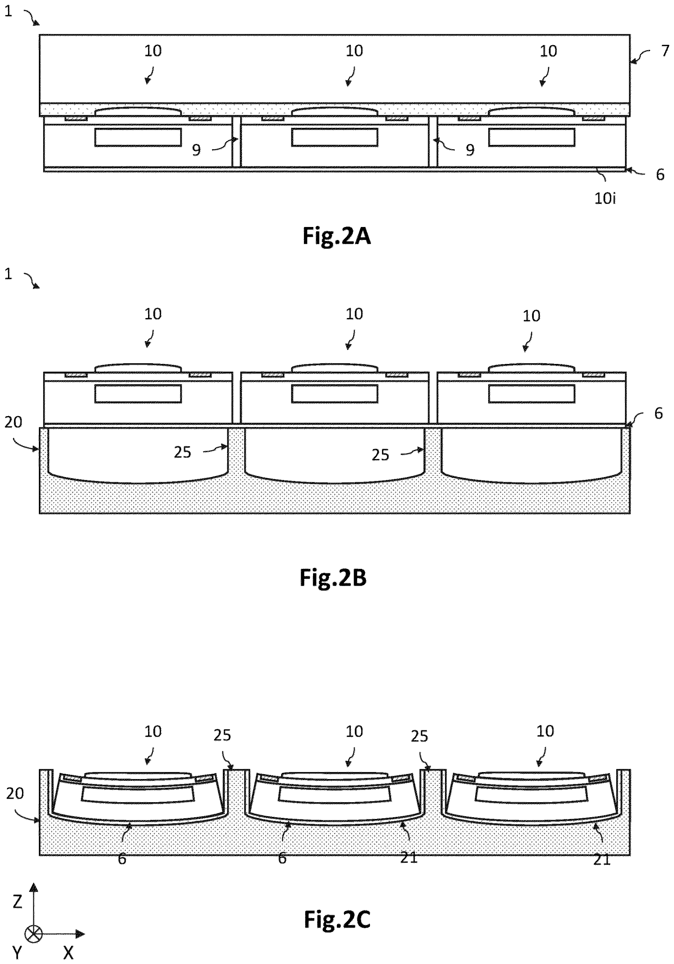

Les figures 2A à 2C illustrent des étapes d'un procédé de mise en courbure collective selon une variante de réalisation. Cette variante se distingue du procédé décrit précédemment essentiellement en ce que la couche adhésive intercalaire 6 est initialement déposée sur la face inférieure 10i des composants optiques 10, et non pas sur la face supérieure 20s du support de mise en forme 20.

La fig.2A illustre une étape de dépôt de la couche adhésive intercalaire 6 sur la face inférieure 10i des composants optiques 10. La couche adhésive intercalaire 6 présente, au moins sur chacune des faces inférieures 10i, une épaisseur constante, par exemple comprise entre 5µm et 100µm.

La fig.2B illustre l'étape de report des composants optiques 10 sur le support de mise en forme 20, de sorte qu'ils reposent sur les parois latérales 25 et adhèrent à ces dernières par la couche adhésive intercalaire 6. Cette étape est similaire ou identique à celle illustrée sur la fig. 1K.

La fig.2C illustre l'étape de mise en forme collective des composants optiques 10. Cette étape est similaire ou identique à l'étape décrite précédemment (en fig. 1L) et n'est pas détaillée à nouveau ici.

Les figures 3A à 3I illustrent des étapes d'un procédé de mise en courbure collective selon une autre variante de réalisation. Cette variante de réalisation se distingue de ce qui a été décrit précédemment en ce que la connexion électrique des composants optiques 10 se fait à partir de la face inférieure 20i du support de mise en forme 20.

En référence à la fig.3A, on retourne la structure obtenue lors de l'étape 1C ou 2A, et on réalise des vias conducteurs 14 (ici TSV, pour *Through Silicon Via,* en anglais) qui s'étendent au travers de chaque composant optique 10 et débouchent sur les plots conducteurs supérieurs 13. On réalise ensuite des plots conducteurs inférieurs 12 reposant sur la face inférieure 2 qui sont connectés aux vias conducteurs 14.

Les plots conducteurs inférieurs 12 sont connectés chacun aux vias conducteurs 14 ici par l'intermédiaire d'une ligne conductrice 16 et d'un plot conducteur intermédiaire 15 (cf. fig.3C). Aussi, la connexion électrique des plots conducteurs inférieurs 12 permet de connecter les photodiodes. En variante, les plots conducteurs inférieurs 12 peuvent être eux-mêmes en contact avec les vias conducteurs 14.

Comme détaillé sur la fig.3C, les plots conducteurs inférieurs 12 sont ici avantageusement agencés le long d'une ligne de niveau 10n de la face inférieure 10i de chaque composant optique 10. Une ligne de niveau 10n de la face inférieure 10i est définie comme étant, lorsque le composant optique 10 est assemblé au support de mise en forme 20 et incurvé selon la courbure de la surface courbée 21, une ligne d'égale distance à la face inférieure 20i du support de mise en forme 20.

La fig.3B illustre ainsi la face inférieure 10i de l'un des composants optiques 10. Y sont représentés les orifices inférieurs des vias conducteurs 14. Ils sont ici agencés autour et à l'extérieur d'une ligne de niveau (trait pointillé) du composant optique 10. Cette ligne de niveau 10n a été prédéterminée en fonction de la position et de la courbure que le composant optique 10 est destiné à avoir lorsqu'il sera assemblé au support de mise en forme 20. Dans cet exemple, la ligne de niveau 10n est circulaire, mais elle pourrait présenter une autre forme.

La fig.3C illustre la même face inférieure 10i du composant optique 10, sur laquelle ont été réalisés les plots conducteurs inférieurs 12, les lignes conductrices 16 et les plots conducteurs intermédiaires 15. Les plots conducteurs intermédiaires 15 sont situés au contact des vias conducteurs 14. Les plots conducteurs inférieurs 12 sont situés sur la ligne de niveau 10n. Les lignes conductrices 16 relient les plots conducteurs intermédiaires 15 aux plots conducteurs inférieurs 12.

Le fait que les plots conducteurs inférieurs 12 soient avantageusement situés le long de la ligne de niveau 10n permet de réaliser des vias conducteurs 22 du support de mise en forme 20 après l'assemblage du composant optique 10 au support de mise en forme 20, et non pas avant cette étape, de sorte qu'ils présentent tous une dimension verticale uniforme, c'est-à-dire la même hauteur, sans risquer de dégrader les composants optiques 10.

Notons que cet agencement des plots conducteurs intermédiaires 15 et des plots conducteurs inférieurs 12 est donné à titre illustratif. D'autres agencements sont possibles. Ainsi, les interconnexions électriques peuvent ne pas comporter les lignes conductrices 16. Les vias conducteurs 14 du composant optique 10 peuvent donc déboucher directement sur les plots conducteurs inférieurs 12, lesquels s'étendent donc de manière à être au moins en partie situés sur la ligne de niveau.

En référence à la fig.3D, on dépose la couche adhésive intercalaire 6 de manière à recouvrir entièrement la face inférieure 2i ainsi que les plots conducteurs inférieurs 12 (et ici les lignes conductrices 16 et les plots conducteurs intermédiaires 15). Elle présente une face inférieure 6i, plane, libre (c'est-à-dire non revêtue par un autre matériau) et continue. La face inférieure 6i est dite continue dans le sens où elle n'est pas traversée par l'un ou l'autre des plots conducteurs 12, 15 (seule la référence 12 est indiquée). Les plots conducteurs 12, 15 ne sont donc pas en saillie hors de cette couche adhésive intercalaire 6. D'un point de vue plus formel, on peut définir une face continue par le fait que deux points quelconques de cette face sont reliés entre eux par un segment dont tous les points appartiennent à la face en question.

En référence à la fig.3E, on effectue le report des composants optiques 10 sur le support de mise en forme 20, de sorte qu'ils reposent sur les parois latérales 25 et adhèrent à ces dernières par la couche adhésive intercalaire 6. Cette étape est similaire ou identique à celle illustrée sur la fig. 1K et sur la fig.2B. On retire le substrat poignée 7 sans décoller les composants optiques 10 du support de mise en forme 20, puisque ces derniers adhèrent aux parois latérales 25 par la couche adhésive intercalaire 6.

En référence à la fig.3F, on effectue la mise en forme collective des composants optiques 10. Cette étape est similaire ou identique à l'étape décrite sur la fig. 1L et sur la fig.2C. La couche adhésive intercalaire 6 est ici au contact de toute la surface courbée 21, et les plots conducteurs 12, 15 ne sont pas au contact de cette surface courbée 21. La couche adhésive intercalaire 6 n'est donc pas traversée par les plots conducteurs inférieurs 12 et intermédiaires 15 qui seraient en saillie. La mise en forme n'est alors pas perturbée par de tels plots en saillie, de sorte que les composants optiques 10 peuvent alors présenter une courbure qui est la courbure voulue (celle des surfaces courbées 21).

En référence à la fig.3G, on assemble à l'empilement ainsi obtenu un substrat poignée 8, permettant de le manipuler lors de l'étape de réalisation des interconnexions électriques dans le support de mise en forme 20. Pour cela, le substrat poignée 8 est assemblée aux parois latérales 25. Une couche de colle (non représentée) peut être utilisée à cette étape. Le substrat poignée 8 peut être une poignée temporaire (par exemple réalisée en silicium), notamment lorsqu'il n'est pas transparent au rayonnement lumineux d'intérêt, ou peut être une poignée permanente (par exemple réalisée en verre) et servir de capot transparent de protection vis-à-vis de chaque composant optique 10.

En référence à la fig.3H, on réalise des vias conducteurs 22 qui s'étendent au travers du support de mise en forme 20 et de la couche adhésive intercalaire 6, à partir de la face inférieure 20i, jusqu'à déboucher directement sur les plots conducteurs inférieurs 12. Pour cela, on réalise les orifices traversants de manière simultanée de sorte qu'ils présentent tous une même hauteur. Dans la mesure où ils débouchent sur les plots conducteurs inférieurs 12, lesquels sont situés sur les lignes de niveau des faces inférieures 10i alors incurvées suivant la courbure imposée par celle des surfaces courbées 21, il n'y a pas de risque que la réalisation des orifices traversants ne dégrade les composants optiques 10. On réalise ensuite les vias conducteurs 22 par remplissage au moins partiel des orifices traversants par un matériau électriquement conducteur.

Les interconnexions électriques du support de mise en forme 20 peuvent également comporter, comme illustré dans cet exemple, des lignes conductrices 23 s'étendant sur la face inférieure 20i. On peut également réaliser des éléments de connexion 24 à un circuit électrique externe (non représenté), par exemple situé dans un circuit imprimé PCB (pour Printed Circuit Board, en anglais). Il s'agit ici de billes en un matériau fusible tel que de l'indium ou un alliage à base de SnAg.

En référence à la fig.3I, on découpe la structure ainsi obtenue pour individualiser les composants optiques 10. Dans cet exemple, le substrat poignée 8 forme un capot permanent dans la mesure où il est réalisé en un matériau transparent au rayonnement lumineux d'intérêt. En variante, il peut être retiré, avant ou après cette opération de découpe. Un capot transparent peut ou non être assemblé aux différents composants optiques 10.

Ainsi, le procédé de mise en courbure collective permet d'obtenir une pluralité de composants optiques 10 incurvés et assemblés à une partie d'un même support 20 de mise en forme et d'interconnexion électrique. Dans la mesure où la couche adhésive intercalaire 6 présente une face inférieure 6i plane et continue (donc sans que les plots conducteurs 12, 15 ne soient en saillie), les composants optiques 10 peuvent effectivement présenter la courbure voulue. De plus, les vias conducteurs 22 sont réalisés après mise en courbure et assemblage, et présentent avantageusement la même hauteur. Pour assurer une bonne connexion électrique sans risquer de dégrader les composants optiques, ils viennent déboucher sur les plots conducteurs inférieurs 12, lesquels sont alors avantageusement situés sur une ligne de niveau de la face inférieure 10i incurvée des composants optiques 10.

Des modes de réalisation particuliers viennent d'être décrits. Différentes variantes et modifications apparaîtront à l'homme du métier.

Ainsi, les composants optiques 10 présentent une configuration BSI. La structure initiale 1 est similaire à celle décrite précédemment en référence à la fig.1A, et en diffère en ce que la couche d'interconnexion (BEOL) affleure la face inférieure 2i et non pas la face supérieure 2s du substrat optique 2. Aussi, la structure initiale 1 comporte ici, pour chaque composant optique 10, des plots conducteurs inférieurs 12 (assurant la connexion à la matrice de photodiodes via la couche d'interconnexion). Ces plots conducteurs inférieurs 12 peuvent être connectés aux vias conducteurs 22 du support de mise en forme 20 (comme illustré sur les fig.3A à 3I), ou être connectés à des fils de connexion via des plots conducteurs supérieurs 13 et des vias conducteurs 14 traversant le substrat optique 2 (comme illustré sur les fig. 1A à 1M).

Par ailleurs, dans le cas des variantes des fig.2A à 2C et des fig.3A à 3I, le support de mise en forme 20 peut comporter des orifices traversants s'étendant au travers du support de mise en forme 20, à partir de la face inférieure 20i jusqu'aux surfaces courbées 21, et situés par exemple au centre de ces dernières. Aussi, ces orifices traversants peuvent être mis à contribution lors de la mise en courbure des composants optiques 10. Pour cela, le gaz situé dans l'espace délimité par la face inférieure 6i de la couche adhésive intercalaire 6 et de la surface courbée 21 est aspiré pour aider à la mise en courbure des composants optiques 10.

## Revendications

1. Procédé de mise en courbure collective de composants microélectroniques (10), comportant les étapes suivantes :
∘ réalisation d'une structure initiale (1), comportant :
• une pluralité de composants microélectroniques (10), présentant une face supérieure (10s) et une face inférieure (10i) opposées, espacés latéralement les uns des autres d'une distance lₜ non nulle ;
• un même substrat poignée (7) temporaire, réalisé en un matériau rigide, qui s'étend continûment en regard des composants microélectroniques (10), et auquel les composants microélectroniques (10) sont tous assemblés par leur face supérieure (10s) ;
∘ fourniture d'un support de mise en forme (20), présentant une face supérieure (20s) et une face inférieure (20i) opposée, la face supérieure (20s) comportant une pluralité de surfaces courbées (21) entourées par des parois latérales (25) ;
∘ dépôt d'une couche adhésive intercalaire (6) recouvrant la face inférieure (10i) des composants microélectroniques (10) ou la face supérieure (20s) du support de mise en forme (20) ;
∘ report de la structure initiale (1) sur le support de mise en forme (20), de sorte que les composants microélectroniques (10) reposent et adhérent au niveau d'une zone d'appui (10a) de leur face inférieure (10i) sur une surface supérieure des parois latérales (25) ;
∘ retrait du substrat poignée (7) temporaire ;
∘ mise en courbure des composants microélectroniques (10), de sorte qu'ils soient incurvés, et adhérent sur les surfaces courbées (21) par la couche adhésive intercalaire (6), celle-ci étant alors au contact de la face inférieure (10i) de chaque composant microélectronique (10) et de la surface courbée (21) correspondante ;
∘ découpe de l'ensemble ainsi obtenu, de manière à individualiser les composants microélectroniques (10), chacun étant alors assemblée à une partie du support de mise en forme (20).

2. Procédé selon la revendication 1, dans lequel l'étape de réalisation de la structure initiale (1) comporte les étapes suivantes :
∘ réalisation d'un substrat microélectronique (2), présentant une face supérieure (2s) et une face inférieure (2i) opposée, comportant la pluralité de composants microélectroniques (10),
∘ réalisation de tranchées (9) dans le substrat microélectronique (2), à partir de sa face supérieure (2s), entourant les composants microélectroniques (10), et présentant une largeur égale à la distance lt ;
∘ assemblage du substrat microélectronique (2) par sa face supérieure (2s) au substrat poignée (7) temporaire auquel sont tous assemblés les composants microélectroniques (10) ;
∘ amincissement du substrat microélectronique (2) à partir de sa face inférieure (2i), jusqu'à rendre traversantes les tranchées (9).

3. Procédé selon la revendication 1 ou 2, comportant, avant l'étape de retrait, une montée en température à une première température comprise dans une gamme de température de réticulation de la couche adhésive intercalaire (6), puis, pendant ou après l'étape de mise en courbure, une montée en température à une deuxième température comprise dans la gamme de température de réticulation et supérieure à la première température.

4. Procédé selon l'une quelconque des revendications 1 à 3, comportant une étape préalable de détermination d'une largeur lₐ de la zone d'appui (10a), comprise entre une valeur minimale prédéfinie l_{a,min} et une valeur maximale l_{a,max} prédéterminée, celle-ci dépendant d'un rayon de courbure R_{c} et de dimensions latérales l_{sc} des surfaces courbées (21), et de dimensions latérales l_{co} des composants microélectroniques (10) avant mise en courbure.

5. Procédé selon l'une quelconque des revendications 1 à 4, la face inférieure (10i) des composants microélectroniques (10) étant, avant le dépôt de la couche adhésive intercalaire (6), une face libre, la couche adhésive intercalaire (6) étant déposée de manière à présenter une épaisseur constante sur la face inférieure (10i) des composants microélectroniques (10) ou sur la face supérieure (20s) du support de mise en forme (20).

6. Procédé selon l'une quelconque des revendications 1 à 4, dans lequel, avant l'étape de retrait du substrat poignée temporaire (7) auquel sont tous assemblés les composants microélectroniques (10), on réalise des plots conducteurs inférieurs (12) sur la face inférieure (10i) des composants microélectroniques (10), adaptés à assurer la connexion électrique des composants microélectroniques (10), et disposés sur une ligne de niveau d'une face inférieure (10i) du composant microélectronique (10) correspondant, la ligne de niveau étant prédéterminée comme étant une ligne d'égale distance à la face inférieure (20i) du support de mise en forme (20), lorsque le composant microélectronique (10) est assemblé au support de mise en forme (10) et est incurvé selon la courbure de la surface courbée (21).

7. Procédé selon la revendication 6, dans lequel, avant l'étape de retrait du substrat poignée temporaire (7) auquel sont tous assemblés les composants microélectroniques (10), on réalise des plots conducteurs supérieurs (13) sur la face supérieure (10s) des composants microélectroniques (10), et des vias conducteurs (14) s'étendant à partir de la face inférieure (10i) des composants microélectroniques (10) et débouchant sur les plots conducteurs supérieurs (13), les plots conducteurs inférieurs (12) étant connectés aux vias conducteurs (14) des composants microélectroniques (10).

8. Procédé selon la revendication 6 ou 7, dans lequel, après l'étape de mise en courbure, un substrat poignée (8) est assemblé aux parois latérales (25) du support de mise en forme (20), de manière à permettre la manipulation de l'empilement ainsi obtenu lors d'une étape de réalisation des vias conducteurs (22) dans le support de mise en forme (20).

9. Procédé selon la revendication 8, dans lequel, après l'étape de mise en courbure, on réalise les vias conducteurs (22) s'étendant au travers du support de mise en forme (20) et de la couche adhésive intercalaire (6), à partir de la face inférieure (20i) du support de mise en forme (20) pour déboucher sur les plots conducteurs inférieurs (12), les vias conducteurs (22) présentant une dimension verticale uniforme.

10. Procédé selon l'une quelconque des revendications 6 à 9, dans lequel les plots conducteurs inférieurs (12) sont disposés au contact des vias conducteurs (14) des composants microélectronique (10), ou sont décalés vis-à-vis de ces vias conducteurs (14) et en sont reliés par des lignes conductrices (16).

11. Procédé selon l'une quelconque des revendications 6 à 10, dans lequel la couche adhésive intercalaire (6) recouvre entièrement la face inférieure (10i) des composants microélectroniques (10) ainsi que les plots conducteurs inférieurs (12), et présente une face inférieure (6i) libre, plane et continue.

12. Procédé selon l'une quelconque des revendications 1 à 11, dans lequel le substrat de mise en forme (20) est réalisé en un seul bloc et en un même matériau.

13. Procédé selon l'une quelconque des revendications 1 à 12, dans lequel le substrat de mise en forme (20) est réalisé en un matériau thermiquement conducteur.

14. Procédé selon l'une quelconque des revendications 1 à 13, dans lequel les composants microélectroniques (10) sont des composants optiques d'émission ou de détection d'un rayonnement lumineux.

## Patentansprüche

1. Verfahren zum gemeinsamen Biegen von mikroelektronischen Komponenten (10), das die folgenden Schritte umfasst:
∘ Herstellen einer Ausgangsstruktur (1), die Folgendes umfasst:
• eine Vielzahl von mikroelektronischen Komponenten (10), die eine obere Fläche (10s) und eine untere Fläche (10i) aufweisen, die sich gegenüberliegen und seitlich voneinander um einen Abstand lₜ ungleich Null beabstandet sind;
• ein gleiches temporäres Griffsubstrat (7) aus einem starren Material, das sich kontinuierlich gegenüber den mikroelektronischen Komponenten (10) erstreckt und an dem alle mikroelektronischen Komponenten (10) mit ihrer oberen Fläche (10s) befestigt sind;
∘ Bereitstellen eines formgebenden Trägers (20), der eine obere Fläche (20s) und eine untere Fläche (20i) aufweist, die sich gegenüberliegen, wobei die obere Fläche (20s) eine Vielzahl von gebogenen Oberflächen (21) umfasst, die von Seitenwänden (25) umgeben sind;
∘ Aufbringen einer Klebezwischenschicht (6), die die untere Fläche (10i) der mikroelektronischen Komponenten (10) oder die obere Fläche (20s) des formgebenden Trägers (20) bedeckt;
∘ Übertragen der Ausgangsstruktur (1) auf den formgebenden Träger (20), so dass die mikroelektronischen Komponenten (10) an einem Auflagebereich (10a) ihrer unteren Fläche (10i) auf einer oberen Oberfläche der Seitenwände (25) aufliegen und haften;
∘ Entfernen des temporären Griffsubstrats (7);
∘ Biegen der mikroelektronischen Komponenten (10), so dass sie gekrümmt sind und durch die Klebezwischenschicht (6) auf den gebogenen Oberflächen (21) haften, wobei diese dann mit der unteren Fläche (10i) jeder mikroelektronischen Komponente (10) und der entsprechenden gebogenen Oberfläche (21) in Kontakt steht;
∘ Zerschneiden der so erhaltenen Anordnung, um die mikroelektronischen Komponenten (10) zu individualisieren, wobei jede dann an einen Teil des formgebenden Trägers (20) montiert wird.

2. Verfahren nach Anspruch 1, wobei der Schritt des Herstellens der Ausgangsstruktur (1) die folgenden Schritte umfasst:
o Herstellen eines mikroelektronischen Substrats (2), das eine obere Fläche (2s) und eine untere Fläche (2i), die sich gegenüberliegen, aufweist und die Vielzahl von mikroelektronischen Komponenten (10) umfasst,
o Herstellen von Gräben (9) im mikroelektronischen Substrat (2) von seiner oberen Fläche (2s) aus, die die mikroelektronischen Komponenten (10) umgeben und eine Breite aufweisen, die gleich dem Abstand lₜ ist;
o Montieren des mikroelektronischen Substrats (2) mit seiner oberen Fläche (2s) auf das temporären Griffsubstrat (7), auf das alle mikroelektronischen Komponenten (10) montiert sind;
o Verdünnen des mikroelektronischen Substrats (2) von seiner unteren Fläche (2i) aus, bis die Gräben (9) durchgehend offen sind.

3. Verfahren nach Anspruch 1 oder 2, das vor dem Schritt des Entfernens einen Temperaturanstieg auf eine erste Temperatur innerhalb eines Vernetzungstemperaturbereichs der Klebstoffzwischenschicht (6) und anschließend, während oder nach dem Schritt des Biegens, einen Temperaturanstieg auf eine zweite Temperatur innerhalb des Vernetzungstemperaturbereichs und höher als die erste Temperatur umfasst.

4. Verfahren nach einem der Ansprüche 1 bis 3, das einen vorherigen Schritt des Bestimmens einer Breite lₐ des Auflagebereichs (10a) umfasst, die zwischen einem vordefinierten Mindestwert l_{a,min} und einem vorgegebenen Maximalwert l_{a,max} liegt, wobei letzterer von einem Biegeradius R_{c} und seitlichen Abmessungen l_{sc} der gebogenen Oberflächen (21) und seitlichen Abmessungen l_{co} der mikroelektronischen Komponenten (10) vor dem Biegen abhängt.

5. Verfahren nach einem der Ansprüche 1 bis 4, wobei die untere Fläche (10i) der mikroelektronischen Komponenten (10) vor dem Aufbringen der Klebezwischenschicht (6) eine freie Fläche ist, wobei die Klebezwischenschicht (6) so aufgebracht wird, dass sie eine konstante Dicke auf der unteren Fläche (10i) der mikroelektronischen Komponenten (10) oder auf der oberen Fläche (20s) des formgebenden Trägers (20) aufweist.

6. Verfahren nach einem der Ansprüche 1 bis 4, wobei vor dem Schritt des Entfernens des temporären Griffsubstrats (7), auf das alle mikroelektronischen Komponenten (10) montiert sind, untere leitende Kontaktstellen (12) auf der unteren Fläche (10i) der mikroelektronischen Komponenten (10) hergestellt werden, die dazu ausgelegt sind, die elektrische Verbindung der mikroelektronischen Komponenten (10) sicherzustellen, und die auf einer ebenen Linie einer unteren Fläche (10i) der entsprechenden mikroelektronischen Komponente (10) angeordnet sind, wobei die Niveaulinie als eine Linie mit gleichem Abstand von der unteren Fläche (20i) des formgebenden Trägers (20) vorbestimmt ist, wenn die mikroelektronische Komponente (10) an den formgebenden Träger (10) montiert und gemäß der Biegung der gebogenen Oberfläche (21) gebogen wird.

7. Verfahren nach Anspruch 6, wobei vor dem Schritt des Entfernens des temporären Griffsubstrats (7), auf dem alle mikroelektronischen Komponenten (10) montiert sind, obere leitende Kontaktstellen (13) auf der oberen Fläche (10s) der mikroelektronischen Komponenten (10) und leitende Durchkontaktierungen (14) hergestellt werden, die sich von der unteren Fläche (10i) der mikroelektronischen Komponenten (10) aus erstrecken und auf den oberen leitenden Kontaktstellen (13) münden, wobei die unteren leitenden Kontaktstellen (12) mit den leitenden Durchkontaktierungen (14) der mikroelektronischen Komponenten (10) verbunden sind.

8. Verfahren nach Anspruch 6 oder 7, wobei nach dem Schritt des Biegens ein Griffsubstrat (8) an die Seitenwänden (25) des formgebenden Trägers (20) montiert wird, um die Handhabung des Stapels zu ermöglichen, der so während eines Schritts des Herstellens der leitenden Durchkontaktierungen (22) im formgebenden Träger (20) erhalten wird.

9. Verfahren nach Anspruch 8, wobei nach dem Schritt des Biegens die leitenden Durchkontaktierungen (22) hergestellt werden, die sich über den gesamten formgebenden Träger (20) und die Klebezwischenschicht (6) von der unteren Fläche (20i) des formgebenden Trägers (20) aus so erstrecken, um auf den unteren leitenden Kontaktstellen (12) zu münden, wobei die leitenden Durchkontaktierungen (22) eine einheitliche vertikale Abmessung aufweisen.

10. Verfahren nach einem der Ansprüche 6 bis 9, wobei die unteren leitenden Kontaktstellen (12) in Kontakt mit den leitenden Durchkontaktierungen (14) der mikroelektronischen Komponenten (10) angeordnet sind oder in Bezug auf die leitenden Durchkontaktierungen (14) versetzt sind und durch Leiterbahnen (16) verbunden sind.

11. Verfahren nach einem der Ansprüche 6 bis 10, wobei die Klebezwischenschicht (6) die untere Fläche (10i) der mikroelektronischen Komponenten (10) sowie die unteren leitenden Kontaktstellen (12) vollständig bedeckt und eine freie, ebene und durchgehende untere Fläche (6i) aufweist.

12. Verfahren nach einem der Ansprüche 1 bis 11, wobei das formgebende Substrat (20) als einteiliger Block und aus dem gleichen Material hergestellt wird.

13. Verfahren nach einem der Ansprüche 1 bis 12, wobei das formgebende Substrat (20) aus einem wärmeleitenden Material hergestellt wird.

14. Verfahren nach einem der Ansprüche 1 bis 13, wobei die mikroelektronischen Komponenten (10) optische Komponenten zur Emission oder Detektion einer Lichtstrahlung sind.

## Claims

1. A method for collective bending of microelectronic components (10), including the following steps:
∘ making an initial structure (1), including:
• a plurality of microelectronic components (10), having an upper face (10s) and a lower face (10i), opposite to each other, spaced laterally apart from each other by a non-zero distance lt;
• a same temporary handle substrate (7), made of a rigid material, which extends continuously opposite the microelectronic components (10), and to which all microelectronic components (10) are assembled by their upper face (10s);
∘ providing a shaping support (20), having an upper face (20s) and an opposite lower face (20i), the upper face (20s) including a plurality of bent surfaces (21) surrounded by lateral walls (25);
∘ depositing an adhesive interlayer (6) covering the lower face (10i) of the microelectronic components (10) or the upper face (20s) of the shaping support (20);
∘ affixing the initial structure (1) onto the shaping support (20), so that the microelectronic components (10) rest and adhere at the level of a bearing area (10a) of their lower face (10i) over an upper surface of the lateral walls (25);
∘ removing the temporary handle substrate (7);
∘ bending the microelectronic components (10), so that they are curved, and adhere over the bent surfaces (21) by the adhesive interlayer (6), the latter then being in contact with the lower face (10i) of each microelectronic component (10) and of the corresponding bent surface (21);
∘ cutting the set thus obtained, so as to individualise the microelectronic components (10), each then being assembled to a portion of the shaping support (20) .

2. The method according to claim 1, wherein the step of making the initial structure (1) includes the following steps:
∘ making a microelectronic substrate (2), having an upper face (2s) and an opposite lower face (2i), including the plurality of microelectronic components (10),
∘ making trenches (9) in the microelectronic substrate (2), starting from its upper face (2s), surrounding the microelectronic components (10), and having a width equal to the distance lₜ;
∘ assembling the microelectronic substrate (2) by its upper face (2s) to the temporary handle substrate (7) to which all microelectronic components (10) are assembled;
∘ thinning the microelectronic substrate (2) starting from its lower face (2i), until the trenches (9) become open-through.

3. The method according to claim 1 or 2, including, before the removal step, a temperature rise up to a first temperature within a crosslinking temperature range of the adhesive interlayer (6), and then, during or after the bending step, a temperature rise up to a second temperature within the crosslinking temperature range and higher than the first temperature.

4. The method according to any one of claims 1 to 3, including a prior step of determining a width lₐ of the bearing area (10a), comprised between a predefined minimum value l_{a,min} and a predetermined maximum value l_{a,max}, the latter depending on a radius of curvature R_{c} and on lateral dimensions l_{sc} of the bent surfaces (21), and on lateral dimensions l_{c}, of the microelectronic components (10) before bending.

5. The method according to any one of claims 1 to 4, the lower face (10i) of the microelectronic components (10) being a free face before deposition of the adhesive interlayer (6), the adhesive interlayer (6) being deposited so as to have a constant thickness over the lower face (10i) of the microelectronic components (10) or over the upper face (20s) of the shaping support (20) .

6. The method according to any one of claims 1 to 4, wherein, before the step of removing the temporary handle substrate (7) to which all microelectronic components (10) are assembled, lower conductive pads (12) are made over the lower face (10i) of the microelectronic components (10), adapted to ensure the electrical connection of the microelectronic components (10), and arranged over a level line of a lower face (10i) of the corresponding microelectronic component (10), the level line being predetermined as being a line equidistant from the lower face (20i) of the shaping support (20), when the microelectronic component (10) is assembled to the shaping support (10) and is curved according to the curvature of the bent surface (21).

7. The method according to claim 6, wherein, before the step of removing the temporary handle substrate (7) to which all microelectronic components (10) are assembled, upper conductive pads (13) are made over the upper face (10s) of the microelectronic components (10), and conductive vias (14) extending from the lower face (10i) of the microelectronic components (10) and opening onto the upper conductive pads (13), the lower conductive pads (12) being connected to the conductive vias (14) of the microelectronic components (10).

8. The method according to claim 6 or 7, wherein, after the bending step, a handle substrate (8) is assembled to the lateral walls (25) of the shaping support (20), so as to enable handling of the stack thus obtained during a step of making the conductive vias (22) in the shaping support (20).

9. The method according to claim 8, wherein, after the bending step, the conductive vias (22) extending throughout the shaping support (20) and the adhesive interlayer (6) are made, starting from the lower face (20i) of the shaping support (20) to open onto the lower conductive pads (12), the conductive vias (22) having a uniform vertical dimension.

10. The method according to any one of claims 6 to 9, wherein the lower conductive pads (12) are arranged in contact with the conductive vias (14) of the microelectronic components (10), or are offset with respect to these conductive vias (14) and are connected by conductive lines (16).

11. The method according to any one of claims 6 to 10, wherein the adhesive interlayer (6) entirely covers the lower face (10i) of the microelectronic components (10) as well as the lower conductive pads (12), and has a free, planar and continuous lower face (6i).

12. The method according to any one of claims 1 to 11, wherein the shaping substrate (20) is made in one-piece and of the same material.

13. The method according to any one of claims 1 to 12, wherein the shaping substrate (20) is made of a heat-conductive material.

14. The method according to any one of claims 1 to 13, wherein the microelectronic components (10) are optical components intended for emitting or detecting a light radiation.
